(19) Europäisches Patentamt / European Patent Office / Office européen des brevets

(11) **EP 3 674 997 A1**

(12) **DEMANDE DE BREVET EUROPEEN**

(43) Date de publication:
**01.07.2020 Bulletin 2020/27**

(51) Int Cl.:
***G06N 10/00*** *(2019.01)*

(21) Numéro de dépôt: **19219565.9**

(22) Date de dépôt: **23.12.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **26.12.2018 FR 1874175**

(71) Demandeur: **Bull SAS**
**78340 Les Clayes-sous-Bois (FR)**

(72) Inventeurs:
• **MARTIEL, Simon**
**95870 BEZONS (FR)**
• **GOUBAULT DE BRUGIERE, Timothee**
**95870 BEZONS (FR)**

(74) Mandataire: **Vigand, Régis Louis Michel**
**Cabinet Plasseraud**
**66, rue de la Chaussée d'Antin**
**FR-75440 Paris Cedex 09 (FR)**

(54) **PROCÉDÉ DE COMPILATION D'UN CIRCUIT QUANTIQUE SUR UN PROCESSEUR QUANTIQUE À IONS PIÉGÉS**

(57) Un procédé de compilation d'un circuit quantique sur un processeur quantique à ions piégés, comprend :
- une obtention d'un circuit quantique contenant uniquement :
\* une première catégorie prédéterminée de portes quantiques à deux qubits,
\* et/ou des portes quantiques à un qubit,

- une étape de compilation des portes quantiques :
\* de manière à ce qu'elles ne contiennent que :
° des portes quantiques collectives ou intricatrices à N qubits d'une troisième catégorie prédéterminée,
° des portes quantiques à un qubit d'une quatrième catégorie prédéterminée,

\*et de manière à ce que tout ou au moins partie de ces portes quantiques collectives ou intricatrices s'appliquent simultanément à au moins trois qubits, s'appliquent avantageusement simultanément à la majorité des qubits, s'appliquent encore plus avantageusement simultanément à tous les qubits

- une étape de regroupement des portes quantiques compilées en un circuit quantique compilé.

FIG. 1

**Description**

**Domaine technique**

L'invention relève du domaine des procédés de compilation d'un circuit quantique sur un processeur quantique à ions piégés.

**Technique antérieure**

Il est connu d'un premier art antérieur Compiling quantum algorithms for architectures with multi-qubit gates, Martinez et al. une méthode de compilation d'un circuit quantique sur un processeur quantique permettant d'obtenir un circuit quantique compilé comprenant un minimum de portes quantiques intricatrices.

La méthode propose de lire toutes les portes d'un circuit quantique et de construire des opérations unitaires, c'est-à-dire une matrice unitaire de taille $2^N$ x $2^N$, avec N le nombre de qubits du circuit quantique. A l'aide d'un optimiseur, des portes intricatrices compilables sur un processeur quantique à ions piégés sont ajoutées. Parallèlement, des portes à déphasages locaux paramétrée selon différents angles sont ajoutées pour faire converger la matrice unitaire. Tant que la matrice unitaire ne converge pas, une nouvelle porte intricatrice est ajoutée au circuit quantique.

Bien que cette méthode soit optimale en termes de résultat, en effet, le circuit obtenu comprend le plus petit nombre de portes quantiques intricatrices, elle est exponentielle en temps et en mémoire, une matrice unitaire de taille $2^N$ x $2^N$ devant être calculée à chaque incrémentation. Cette méthode ne peut donc pas s'appliquer pour des circuits quantiques de plus de quatre qubits.

Une autre méthode connue est décrite dans le document *Basic circuit compilation techniques for an ion-trap quantum machine,* Maslov et Use of global interactions in efficient quantum circuit constructions, Maslov et Nam.

Cette méthode propose de programmer certains blocs du circuit quantique dans un langage lisible par un processeur quantique à ions piégés. Certains blocs du circuit quantique sont réécrits en utilisant des portes quantiques intricatrices compilables sur un processeur à ions piégés.

Toutefois, cette méthode n'est pas automatique, puisque la programmation est faite par un programmeur. Ainsi, le risque est que le programmeur ne décèle pas certains blocs du circuit quantique à réécrire. Cette méthode n'est donc pas optimale.

**Problème technique**

Ces solutions connues ne permettent pas de compiler un circuit quantique de manière automatisée, tout en permettant une compilation rapide et efficace de l'ensemble du circuit quantique.

L'invention vient pallier au moins partiellement les inconvénients de l'art antérieur et optimiser la compilation de circuits quantiques sur des processeurs quantiques à ions piégés.

Pour cela, selon l'invention, il va être intéressant de transformer le circuit quantique pour qu'il ne reste que des portes quantiques exécutables par le processeur quantique, et de mutualiser automatiquement certaines de ces portes quantiques à plusieurs qubits, et préférentiellement à une majorité voire à la totalité des qubits. Cette mutualisation permet, d'une part, de rendre la compilation très efficace, et, d'autre part, la mutualisation permet de limiter le nombre de portes quantiques complexes dans ce circuit quantique, rendant ainsi plus facile le passage à l'échelle lorsque le nombre de qubits du circuit est augmenté car il suffit alors de mutualiser également ces portes quantiques sur les qubits supplémentaires.

Le procédé de compilation selon l'invention permet donc la compilation d'un circuit quantique de manière complètement automatisée et optimisée en termes d'efficacité.

Il est proposé un procédé de compilation d'un circuit quantique sur un processeur quantique à ions piégés, comprenant :

- une éventuelle étape préalable de transformation du circuit quantique de manière à ce qu'il ne contienne plus que :

  * une première catégorie prédéterminée de portes quantiques à deux qubits,
  * et/ou des portes quantiques à un qubit,

- une étape de compilation des portes quantiques :

  * de manière à ce qu'elles ne contiennent que :

    ° des portes quantiques collectives ou intricatrices à N qubits d'une troisième catégorie prédéterminée,

° des portes quantiques à un qubit d'une quatrième catégorie prédéterminée,

*et de manière à ce que tout ou au moins partie de ces portes quantiques collectives ou intricatrices s'appliquent simultanément à au moins trois qubits, s'appliquent avantageusement simultanément à la majorité des qubits, s'appliquent encore plus avantageusement simultanément à tous les qubits

- une étape de regroupement des portes quantiques compilées en un circuit quantique compilé..

Selon un autre aspect, il est proposé un Procédé de compilation d'un circuit quantique sur un processeur quantique à ions piégés comprenant :

- une étape de décomposition de tout ou partie du circuit quantique en un ou plusieurs polynômes de phase,
- une étape de recomposition directe dudit tout ou partie du circuit quantique sous forme de portes quantiques intricatrices de Molmer-Sorensen sans passer sous la forme de portes quantiques CNOT,
- une étape de regroupement des portes quantiques recomposées pour obtenir un circuit compilé.

Par ailleurs, la décomposition de tout ou partie du circuit quantique en polynômes de phase permet de réécrire ces parties du circuit quantique directement sous forme de portes quantiques intricatrices de Molmer-Sorensen. Autrement dit, il n'est pas nécessaire de recomposer ces parties du circuit quantique sous forme d'autres portes de type CNOT. Le procédé permet donc de limiter le nombre d'étapes lors de la recomposition, augmentant ainsi, d'une part, l'efficacité de sa mise en œuvre, et, d'autre part, sa rapidité de compilation.

Les caractéristiques exposées dans les paragraphes suivants peuvent, optionnellement, être mises en œuvre. Elles peuvent être mises en œuvre indépendamment les unes des autres ou en combinaison les unes avec les autres :

De préférence, le procédé comprend en outre, entre l'éventuelle étape préalable de transformation et l'étape de compilation des portes quantiques :

- une étape de séparation dudit circuit quantique en :

   * couches locales comprenant uniquement des portes quantiques à un qubit,
   * couches intricatrices comprenant uniquement :

      °des portes quantiques à deux qubits de la première catégorie,
      ° et/ou des portes quantiques à un qubit d'une deuxième catégorie prédéterminée,

- ladite étape de compilation des portes quantiques comprenant aussi :

   * une étape de compilation des couches locales,
   * une étape de compilation des couches intricatrices, séparée de l'étape de compilation des couches locales,
   * l'étape de compilation des couches intricatrices transformant les portes quantiques de ces couches intricatrices de manière à ce qu'elles ne contiennent que :

      ° des portes quantiques collectives ou intricatrices à N qubits de la troisième catégorie prédéterminée,
      ° des portes quantiques à un qubit de la quatrième catégorie prédéterminée,

- ladite étape de regroupement des portes quantiques compilées en un circuit quantique compilé est une étape de regroupement comprenant un regroupement des couches locales compilées et des couches intricatrices compilées en un circuit quantique compilé.

Ainsi, selon l'invention, il va être intéressant de découper le circuit quantique en couches de différents types. Les couches du circuit quantique sont découpées de manière à ne comprendre que des portes quantiques d'un certain type prédéterminé. Ce découpage permet, d'une part, de pouvoir compiler ces couches selon un traitement de compilation spécifique aux portes quantiques contenues dans ces couches. L'application de traitements de compilation spécifiques permet d'augmenter grandement l'efficacité du procédé de compilation. D'autre part, le découpage permet de regrouper plusieurs portes quantiques dans une même couche afin d'appliquer un unique traitement de compilation pour une pluralité de portes, permettant ainsi d'augmenter notablement la rapidité de la compilation de l'ensemble du circuit quantique.

Le procédé de compilation selon l'invention permet donc la compilation d'un circuit quantique de manière complètement automatisée et optimisée, tant en termes d'efficacité qu'en termes de rapidité de la compilation.

De préférence, l'étape de compilation des couches intricatrices comprend :

- une décomposition de chaque couche intricatrice en un polynôme de phase,
- une recomposition directe sous forme de portes quantiques de la troisième catégorie et de la quatrième catégorie de portes quantiques sans passer par une forme de portes quantiques de la première catégorie de portes quantiques.

Ainsi, la décomposition de tout ou partie du circuit quantique en polynômes de phase permet de réécrire ces parties du circuit quantique directement sous forme de portes quantiques intricatrices de Molmer-Sorensen. Autrement dit, il n'est pas nécessaire de recomposer ces parties du circuit quantique sous forme d'autres portes de type CNOT. Le procédé permet donc de limiter le nombre d'étapes lors de la recomposition, augmentant ainsi d'une part, l'efficacité de sa mise en œuvre, et, d'autre part, sa rapidité de compilation.

De préférence, l'étape de compilation des couches locales comprend :

- une décomposition de chaque matrice locale de couche locale en une séquence de portes quantiques d'une rotation selon l'axe Z, d'une rotation selon l'axe X, d'une rotation selon l'axe Z,
- une sous-décomposition de la rotation selon l'axe X en une séquence de portes quantiques de Hadamard, d'une rotation selon l'axe Z, de Hadamard,
- une sous-sous-décomposition, de la porte de Hadamard en une séquence de portes quantiques d'une rotation selon l'axe Z, d'une rotation selon l'axe X, d'une rotation selon l'axe Z, toutes trois rotations d'un angle de pi ou pi/2,
- une mutualisation entre qubits, des portes de rotation selon l'axe X d'un angle de pi/2.

Cette décomposition des couches locales permet d'obtenir des portes quantiques d'une rotation selon l'axe X ayant un angle fixé. Les portes à rotation selon l'axe X ne dépendent donc plus des matrices locales, ce qui permet de mutualiser les portes quantiques à rotation selon l'axe X à une majorité de qubits des couches locales, et préférentiellement à tous les qubits des couches locales. Par ailleurs, une telle décomposition permet d'obtenir un circuit quantique recomposé à partir des couches locales qui ne contient que deux portes collectives à rotation selon l'axe X, ce qui améliore grandement la précision du procédé.

De préférence, le procédé comprend :

- une étape préalable de transformation du circuit quantique de manière à ce qu'il ne contienne plus que :

    * une première catégorie prédéterminée de portes quantiques à deux qubits,
    * et/ou des portes quantiques à un qubit.

Ainsi, cette étape préalable permet de transformer le circuit afin qu'il ne contienne plus que des portes quantiques sur lesquelles les étapes du procédé selon l'invention peuvent être mises en œuvre.

De préférence, lors de l'étape de compilation des couches intricatrices :

- le nombre de portes quantiques collectives ou intricatrices de la troisième catégorie de portes quantiques dans les couches intricatrices compilées est minimisé en priorité par rapport à la minimisation des portes quantiques de la quatrième catégorie.

Les portes intricatrices et collectives de la troisième catégorie étant les plus coûteuses en termes de temps d'exécution et de précision du procédé, le minimisation de leur nombre en priorité permet d'obtenir un circuit quantique moins coûteux en terme de temps d'exécution, et plus précis lors de sa compilation.

De préférence, la première catégorie prédéterminée de portes quantiques à deux qubits comprend :

    * des portes quantiques diagonales à deux qubits,
    * des portes quantiques CNOT,

- la troisième catégorie prédéterminée de portes quantiques à deux qubits comprend :

    * des portes intricatrices Molmer-Sorensen à N qubits,
    * des portes collectives à rotation suivant l'axe X,

- la quatrième catégorie prédéterminée de portes quantiques à un qubit comprend :

    * des déphasages locaux suivant l'axe Z.

De préférence, la deuxième catégorie prédéterminée de portes quantiques à un qubit comprend :

* des portes diagonales à un qubit.

Les portes quantiques des quatre catégories prédéterminées correspondent donc aux portes quantiques pouvant être exécutées sur un processeur quantique à ions piégés.

## Brève description des dessins

D'autres caractéristiques, détails et avantages de l'invention apparaîtront à la lecture de la description détaillée ci-après, et à l'analyse des dessins annexés, sur lesquels :

**Fig. 1**

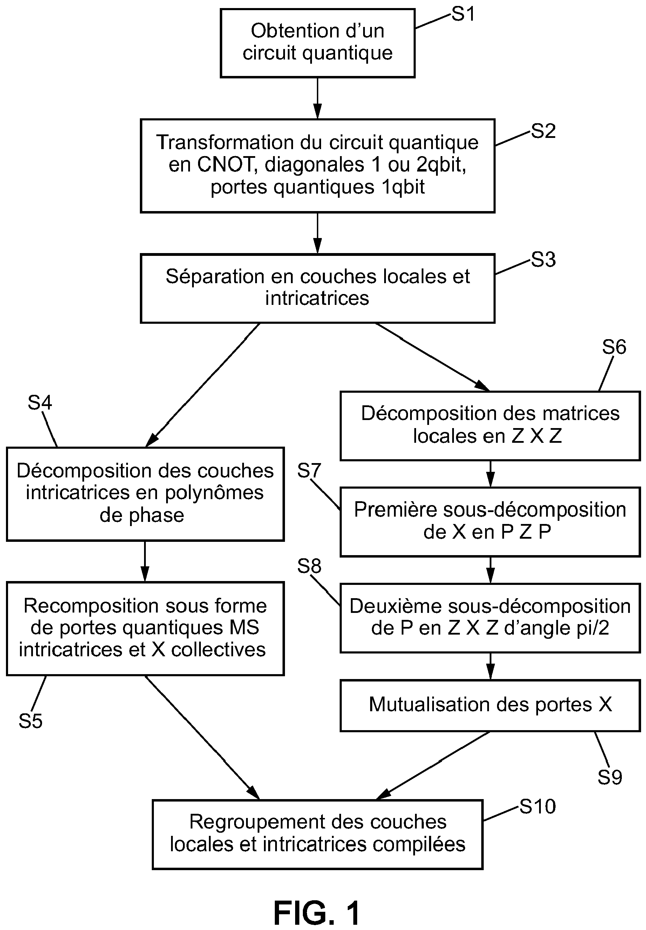

[Fig. 1] montre un ordinogramme des principales étapes d'un procédé de compilation d'un circuit quantique sur un processeur quantique à ions piégés selon un mode de réalisation de l'invention.

**Fig. 2a**

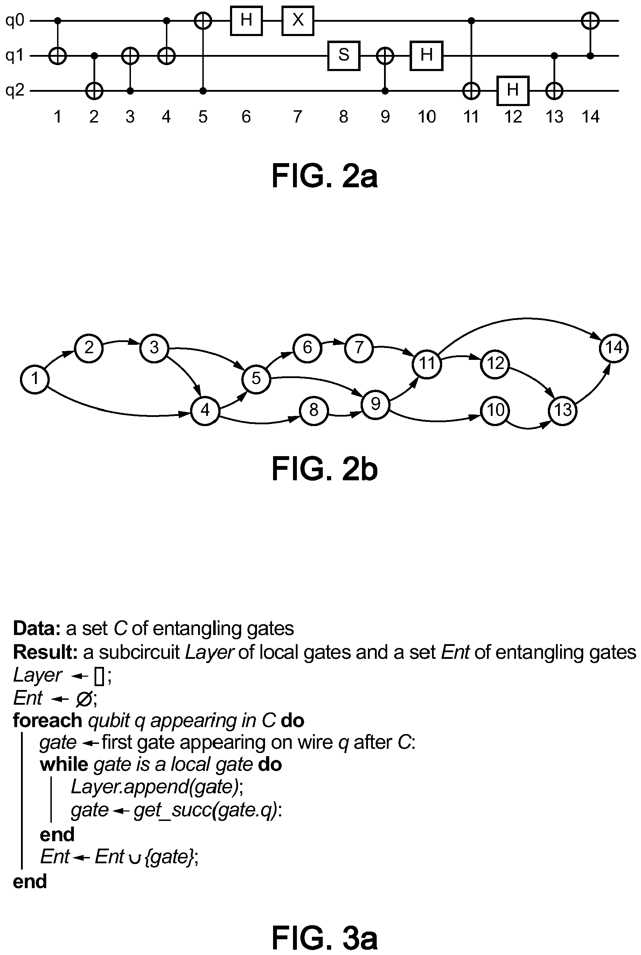

[Fig. 2a] montre une représentation d'un circuit quantique comprenant des portes quantiques à deux qubits de la première catégorie prédéterminée et des portes quantiques à un qubit, avant la séparation du circuit quantique en couches locales et intricatrices.

**Fig. 2b**
[Fig. 2b] montre un graphe orienté acyclique du circuit quantique de la figure 2b, utilisé, dans un mode de réalisation particulier de l'invention, pour effectuer la séparation du circuit quantique en couches locales et intricatrices.

**Fig. 3a**
[Fig. 3a] montre un pseudo code pour l'extraction des couches locales selon un mode de réalisation de l'invention.

**Fig. 3b**

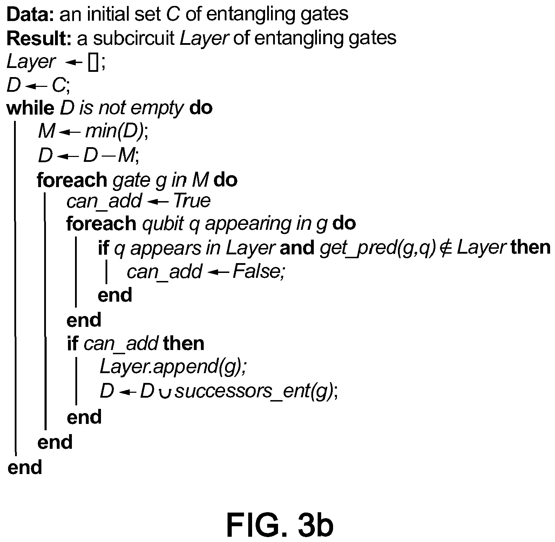

[Fig. 3b] montre un pseudo code pour l'extraction des couches intricatrices selon un mode de réalisation de l'invention.

**Fig. 4**

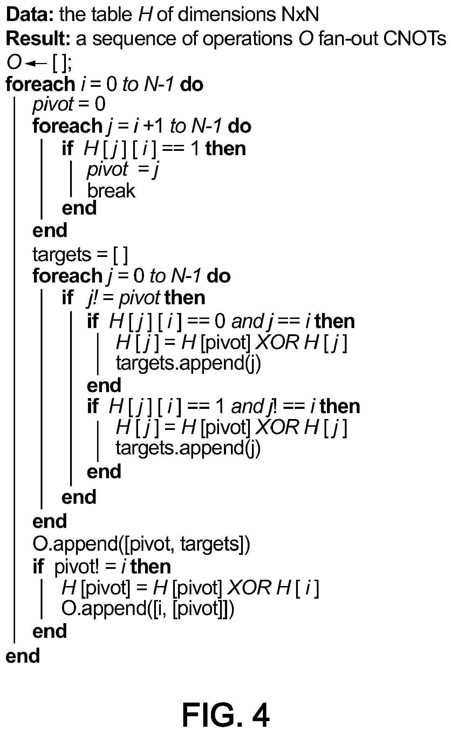

[Fig. 4] montre un pseudo code d'une élimination gaussienne utilisé pour la recomposition des couches intricatrices selon un mode de réalisation de l'invention.

**Fig.5**

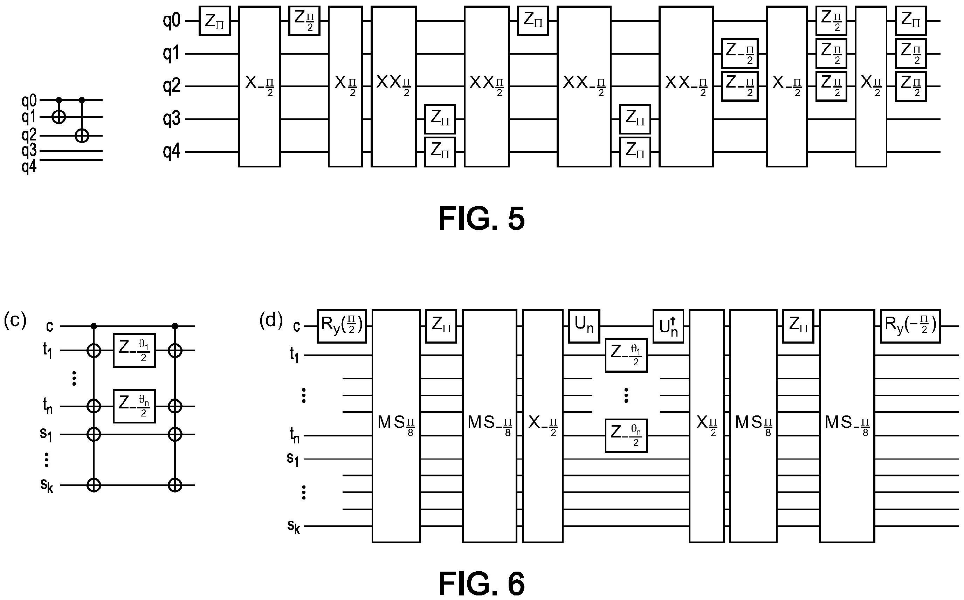

[Fig. 5]. montre un exemple de recomposition d'une couche intricatrice en un circuit quantique comprenant uniquement des portes quantiques collectives ou intricatrices à N qubits d'une troisième catégorie prédéterminée et des portes quantiques à un qubit d'une quatrième catégorie prédéterminée

**Fig. 6**
[Fig. 6] montre un autre exemple de recomposition d'une couche intricatrice en un circuit quantique comprenant uniquement des portes quantiques collectives ou intricatrices à N qubits d'une troisième catégorie prédéterminée et des portes quantiques à un qubit d'une quatrième catégorie prédéterminée.

**Fig. 7**

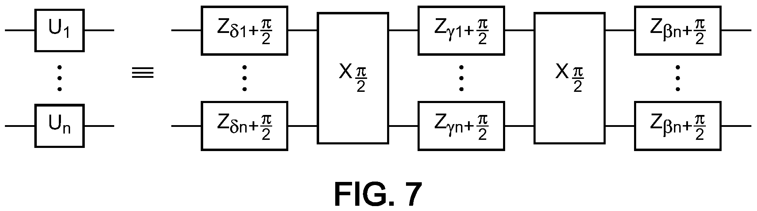

[Fig. 7] montre un exemple de circuit quantique issu de la compilation d'une couche locale.

## Description des modes de réalisation

Il est maintenant fait référence à la figure 1, sur laquelle les principales étapes d'un procédé de compilation d'un circuit quantique sur un processeur quantique à ions piégés sont illustrées.
A l'étape d'obtention S1, un circuit quantique est obtenu. Le circuit quantique est avantageusement composé de portes quantiques à deux qubits d'une première catégorie prédéterminée de portes quantiques, et/ou de portes quantique à un qubit.
Plus précisément, le circuit quantique est avantageusement composé de portes quantiques CNOT et de portes quantiques diagonales quelconque à deux qubits, formant les portes quantiques de la première catégorie prédéterminée, et/ou des portes quantiques à un qubit.

Une étape de transformation S2 peut éventuellement être appliquée au circuit quantique. L'étape de transformation S2 est appliquée lorsque le circuit quantique est composé de portes quantiques autres que celles de la première catégorie prédéterminée ou de portes quantiques à un qubit. L'étape de transformation S2 comprend une transformation du circuit quantique afin que ce circuit quantique ne comprenne plus que des portes quantiques de la première catégorie prédéterminée de portes quantiques, et/ou des portes quantique à un qubit.

Dans le cas où le circuit quantique ne comprend que des portes quantiques de la première catégorie prédéterminée de portes quantiques, et/ou des portes quantique à un qubit, l'étape de séparation S3 est mise en œuvre directement après l'étape d'obtention S1.

Une étape de séparation S3 est ensuite mise en œuvre. L'étape de séparation S3 comprend la séparation du circuit quantique en couches locales et en couches intricatrices. Les couches locales comprennent uniquement des portes quantiques à un qubit. Les couches intricatrices comprennent uniquement des portes quantiques à deux qubits de la première catégorie et/ou des portes quantiques à un qubit d'une deuxième catégorie.

Les portes quantiques à un qubit de la deuxième catégorie sont des portes quantiques diagonales quelconques à un qubit.

L'étape de séparation S3 comprend la génération d'un graphe orienté acyclique associé au circuit quantique.

La figure 2a illustre un exemple de circuit quantique à trois qubits q0, q1 et q2, comprenant quatorze opérations quantiques, soit quatorze portes quantiques. La figure 2b illustre le graphe orienté acyclique correspondant au circuit quantique de la figure 2a. le graphe orienté acyclique permet de représenter les dépendances entre les opérations quantiques. Ainsi, sur ce graphe, les sommets représentent les portes quantiques 1 à 14, et les arêtes représentent les dépendances entre les portes quantiques.

Les figures 2a et 2b sont purement illustratives, un circuit quantique comprenant un nombre bien supérieur de qubits, par exemple supérieur à 10 qubits, de préférence supérieur à 20 qubits et de préférence supérieur à 30 qubits, pouvant être utilisé. Un circuit quantique comprenant un nombre bien supérieur de portes quantiques peut également être utilisé.

A partir du graphe orienté acyclique, la séparation du circuit quantique en couches locales et en couches intricatrices est effectuée. Plus précisément, la séparation se fait en construisant successivement la plus grande couche locale à partir de la dernière couche intricatrice. Ceci est répété jusqu'à ce que toutes les portes quantiques soient comprises dans une couche local ou intricatrice.

La séparation peut être faite de manière séquentielle, c'est-à-dire en commençant de la porte 1 jusqu'à la porte 14.

La figure 3a illustre un pseudo code mis en œuvre pour la séparation du circuit en couches locales. Dans ce pseudo code, la fonction get_succ renvoie la première porte succédant à la porte quantique g sur le qubit q. Autrement dit, les portes quantiques succédant la porte quantique g sur le qubit q sont regroupées en une couche locale, tant que ces portes quantiques sont des portes quantiques locales, c'est-à-dire des portes quantiques à 1 qubit.

La figure 3b illustre un pseudo code mis en œuvre pour la séparation du circuit en couches intricatrices. Dans ce pseudo code, la fonction get_pred renvoie la première porte précédent la porte g sur le qubit q et la fonction successors_ent renvoie la liste des portes quantiques intricatrices succédant à g, pour tous les qubits.

Autrement dit, les couches intricatrices peuvent comprendre des portes quantiques à un qubit, telles que les portes quantiques diagonales à un qubit, en plus des portes intricatrices à deux qubits, qui elles ne peuvent pas être comprises dans les couches locales.

Les étapes S4 et S5 illustrent la compilation des couches intricatrices. Les étapes S4 et S5 visent à obtenir un circuit quantique ne comprenant que des portes quantiques d'une troisième catégorie et d'une quatrième catégorie de portes quantiques. Les portes quantiques de la troisième catégorie et de la quatrième catégorie de portes quantiques correspondant à des portes quantiques exécutables sur un processeur quantique à ions piégés.

Notamment, les portes quantiques de la troisième catégorie comprennent des portes intricatrices Molmer-Sorensen à N qubits et des portes collectives à rotation suivant l'axe X. Les portes quantiques de la quatrième catégorie comprennent des déphasages locaux selon l'axe Z (ou à rotation selon l'axe Z).

L'étape de décomposition des couches intricatrices S4 comprend la décomposition des couches intricatrices en polynômes de phase.

Plus précisément, à ce stade du procédé, les couches intricatrices comprennent uniquement des portes quantiques à deux qubits de la première catégorie et/ou des portes quantiques à un qubit de la deuxième catégorie, c'est à dire des portes quantiques CNOT et/ou des portes quantiques diagonales à un qubit.

Tout circuit contenant de telles portes quantiques peut s'écrire sous la forme :

$$U|x_1\ldots x_n> = e^{ip(x_1\cdots x_n)}|h(x_1\ldots x_n)>,$$

Où *h* est linéaire et *p* est de la forme :

$$P(x_1 \dots x_n) = \Sigma\theta_i.f_i\,(x_1 \dots x_n),$$

Et où les *fi* sont des fonctions linéaires.

Afin de déterminer *h*, une matrice **H** comprenant des 0 et des 1, de dimension NxN est construite, avec N le nombre de qubits de la couche intricatrice. La matrice **H** est initialisée à l'identité, c'est-à-dire en matrice comprenant une diagonale de 1.

Afin de déterminer les fonctions linéaires *fi*, une table de hachage **F** est construite. La table de hachage **F** hache les éléments de la matrice **H** vers des flottants.

Une pluralité de modèles d'exécution est alors définie. Notamment, lors de la lecture des portes quantiques de la couche intricatrice, lorsque :

- la porte quantique est une porte quantique CNOT du qubit i vers le qubit j, alors **H[j] = H[j] XOR H[i],** avec XOR correspondant au XOT bit à bit de deux séquences de bits,

- la porte quantique est une rotation selon Z d'angle a sur le qubit i, alors :

   ◦ si **F[H[i]]** est vide alors **F[H[i]]** = a,

   ◦ sinon, **F[H[i]]** = **F[H[i]]** + a,

- la porte quantique est une phase contrôlée d'angle a du qubit i vers le qubit j, alors :

   ◦

$$F[\,H[\,i\,]\ XOR\ H[j]\,] \mathrel{+}= -a/2,$$

   ◦

$$F[\,H[\,i\,]\,] \mathrel{+}= a/2,$$

   ◦

$$F[\,H[\,j\,]\,] \mathrel{+}= a/2.$$

Une fois ces modèles d'exécution implémentés, la matrice **H** est décomposée en une suite d'opérations correspondant à une séquence de portes quantiques au moyen d'une élimination Gaussienne.

La figure 4 illustre le pseudo code mis en œuvre pour l'élimination Gaussienne appliquée à la matrice **H.**

L'élimination Gaussienne permet d'obtenir une séquence O d'opérations qui décomposent la matrice **H.** Chaque opération de cette séquence O est un ensemble de portes de type CNOT partageant le même qubit de contrôle. Ces portes sont couramment appelées des portes fan-out CNOT. L'élimination Gaussienne est appliquée à chaque ligne 0 à N de la matrice **H,** respectivement à chaque itérations J=0 à J=N-1. Par application itérative de l'élimination Gaussienne à chaque ligne de la matrice **H,** une séquence de fan-out CNOT, de taille linéaire égale à N est obtenue.

Puis, une étape de recomposition des couches intricatrices S5 est effectuée. Cette étape de recomposition des couches intricatrices S5 comprend la recomposition des couches intricatrices pour qu'elles comprennent uniquement des portes quantiques intricatrices Molmer-Sorensen, des portes quantiques collectives à rotation suivant l'axe X, des portes quantiques à déphasages locaux suivant l'axe Z.

Cette recomposition est effectuée de manière directe. Plus précisément, cela signifie que le circuit quantique comprenant uniquement des portes quantiques intricatrices Molmer-Sorensen, des portes quantiques collectives à rotation suivant l'axe X, des portes quantiques à déphasages locaux suivant l'axe Z est obtenu directement après l'étape de décomposition S4, sans passer par une autre forme de porte quantique (notamment des portes quantiques CNOT).

Lorsque la séquence de fan-out CNOT a été obtenue à l'étape de décomposition S4, un nombre linéaire de tables **H0, H1,** ..., **HN,** correspondant à la matrice **H** à chaque itération j=0 à j=N de l'élimination Gaussienne, est obtenue.

Une pluralité de modèles d'exécution est déterminée pour l'étape de recomposition. Notamment :

- si une ligne **Hk[j]** apparait dans la matrice **F,** une porte quantique à rotation Z d'angle **F[Hk[j]]** est ajoutée sur le qubit j après la fan-out CNOT numéro k,

- Si une entrée **F[b]** n'apparait nulle part dans la séquence de Hi, avec Hi appartient aux tables **H0, H1,** ..., **HN** :

  ○ et s'il existe une table Hk et deux qubits c et t tels que **Hk[c]** XOR **Hk[t] == b,** avec **b** une table choisie, alors, la phase **F[b]** est insérée via une heuristique décrite ci-après,

  ○ s'il n'existe pas une telle table **Hk**, la phase est insérée à la fin de la séquence O d'opérations telle que :

    ▪ est inséré un ensemble de portes quantiques CNOT partageant le même qubit cible (couramment appelée une fan-in CNOT) ayant pour qubits de contrôle tous ceux pour lesquels un bit égal à 1 est présent dans **b** excepté un qubit y, ce dernier qubit y étant le qubit cible,

    ▪ est insérée une porte quantique à rotation selon Z d'angle **F[b]** sur le qubit y,

    ▪ insertion de la même fan-in CNOT.

Les phases restantes sont insérées suivant une heuristique utilisant des portes quantiques de type fan-out PHASES. Une fan-out PHASE est un ensemble de portes quantiques à phases contrôlées de la forme :

$$\cos(angle/2)I - i\sin(angle/2)ZZ.$$

Les fan-out PHASES partagent le même qubit de contrôle. Ces fan-out PHASES sont insérées telles que :

- pour chaque phase **F[b]** tel qu'il existe **k, c, t** comme ci-dessus ;

  ○ si c est déjà utilisé comme qubit de contrôle lors de l'insertion d'une phase dans **Hk** via une fan-out PHASE, alors une phase de c vers t avec un angle **F[b]** est inséré dans la fan-out PHASE correspondante,

  ○ sinon une nouvelle fan-out PHASE d'une seule phase de c vers t avec comme angle **F[b]** est insérée.

Le même schéma est effectué avec t, si t est déjà utilisé.
La figure 6 est un exemple de recomposition d'une porte quantique fan-out CNOT ayant deux qubits cibles, en un circuit quantique comprenant uniquement des portes quantiques intricatrices Molmer-Sorensen, des portes quantiques collectives à rotation selon l'axe X et des déphasages locaux selon l'axe Z.
La figure 7 illustre une recomposition de fan-out PHASES en un circuit quantique comprenant uniquement des portes quantiques intricatrices Molmer-Sorensen, des portes quantiques collectives à rotation selon l'axe X et des déphasages locaux selon l'axe Z.
Lors de la recomposition des circuits, le nombre de portes intricatrices Molmer-Sorensen et de portes quantiques collectives à rotation selon l'axe X est minimisé en priorité, ces portes étant les plus coûteuses en termes de temps d'exécution et de précision du circuit quantique.
Le nombre de portes intricatrices Molmer-Sorensen et de portes quantiques collectives à rotation selon l'axe X peut être constant.
Les étapes S6 à S9 illustrent ensuite la compilation des couches locales. La compilation des couches locales vise à obtenir un circuit quantique comportant uniquement des portes quantiques à rotation selon l'axe Z et d'une rotation selon l'axe X. Avantageusement, les portes quantiques à rotation selon l'axe X sont collectives, c'est-à-dire qu'il est possible de mutualiser une porte quantique à rotation selon l'axe X à plusieurs qubits du circuit quantique, et encore plus avantageusement à tous les qubits.
La compilation des couches locales comprend une étape de décomposition des couches locales S6. L'étape de décomposition des couches locales S6 comprend un calcul des matrices locales U à appliquer à chaque qubit. Ces matrices locales U sont décomposées en portes quantiques à rotation suivant l'axe X, suivant l'axe Z et suivant l'axe X. La décomposition ZXZ permet d'obtenir trois angles a, b et c tels que :

- U = Rz(a)Rx(b)Rz(c), où Rz et Rx correspondent aux rotations à un qubit autor des axes Z et X.

Une première étape de sous-décomposition S7 est ensuite mise en œuvre. La première étape de sous-décomposition S7 comprend la sous-décomposition des portes quantiques à rotation suivant l'axe X en portes quantiques de Hadamard P, de rotation selon l'axe Z et de Hadamard. P

Puis, une deuxième étape de sous-décomposition S8 est mise en œuvre. La deuxième étape de sous-décomposition S8 utilise l'identité Rx(b) = P Rz(b), où P est une porte Hadamard, et P= Rz(pi/2) Rx(pi/2) Rz(pi/2). Chaque matrice locale peut ainsi être formulée comme suit :

$$U = Rz(a + pi/2) \ Rx(pi/2) \ Rz(b + pi) \ Rx(pi/2) \ Rz(c + pi/2)$$

Enfin, une étape de mutualisation S9 est mise en œuvre. L'étape de mutualisation collectivise les portes quantiques à rotation selon l'axe X à tous les qubits. En effet, les Rx de la formule ne dépendent pas de la matrice locale U car elles sont d'angle fixé pi/2. Ainsi, à partir de chaque matrice locale U1... UN, un circuit quantique comprenant des portes à rotation selon l'axe Z et des portes collectives à rotation selon l'axe X peut être obtenu, comme illustré sur la figure 8.

Le procédé de compilation selon l'invention comprend une étape de regroupement S10, lors de laquelle les couches locales et intricatrices compilées sont concaténées pour obtenir le circuit quantique compilable sur le processeur quantique à ions piégés.

Ce circuit quantique comprend donc uniquement des portes exécutables par le processeur quantique à ions piégés. Plus précisément, ce circuit quantique comprend des portes quantiques collectives à rotation selon l'axe X, des portes quantiques intricatrices Molmer-Sorensen et des portes quantiques à déphasages locaux suivant l'axe Z.

Une étape supplémentaire de réduction de la taille du circuit quantique peut en outre être effectuée. Notamment, au maximum deux portes quantiques à rotations collectives selon l'axe X peuvent se suivre sans redondances. Il est ainsi possible de fusionner des circuits quantiques contenant plus de deux rotations collectives selon l'axe X pour ensuite les redécomposer selon une méthode choisie au préalable, produisant ainsi un circuit quantique compilable plus concis.

A titre d'exemple, un tableau comparatif présentant les résultats des différentes méthodes de l'art antérieur par rapport aux résultats du procédé selon l'invention est décrit ci-après.

[Tableau 1]

| Circuit | Méthode (1) | Méthode (2) | Méthode (3) | Méthode (4) |
|---------|-------------|-------------|-------------|-------------|
| QFA-5 | 30 | 23 | 52 | 36 |
| QFA-10 | 135 | 53 | 112 | 76 |
| QFA-15 | 315 | 83 | 172 | 116 |
| QFA-20 | 570 | 113 | 232 | 156 |
| QFA-n | $3^{\wedge}(n(n-1)/2)$ | 6n - 7 | 12n - 8 | 8n - 4 |
| QFT-5 | 10 | 7 | 16 | 16 |
| QFT-10 | 45 | 17 | 36 | 36 |
| QFT-15 | 105 | 27 | 56 | 56 |
| QFT-20 | 190 | 37 | 76 | 76 |
| QFT-n | n(n-1)/2 | 2n - 3 | 4n -4 | 4n -4 |

La première colonne « méthode (1) » présente les résultats du premier art antérieur décrit. La deuxième colonne « méthode (2)» présente les résultats du premier art antérieur décrit, dans lequel la compilation est effectuée manuellement, en posant des hypothèses réductrices telles que la semi-localité des portes Molmer-Sorensen ou la diminution de la force d'interaction des qubits entre eux au cours de l'application d'une porte Molmer-Sorensen. La troisième colonne « méthode (3) » correspond à la même implémentation, sans les hypothèses réductrices décrites ci-avant. La quatrième colonne « méthode (4)» correspond au procédé selon l'invention.

Par résultat, on entend le nombre de portes quantiques comprises dans le circuit quantique compilé par la méthode associée.

La première ligne correspond à une implémentation d'une transformée de Fourier quantique sur un circuit quantique à 5, 10, 15, 20 qubits. La ligne suivant correspond à cette même implémentation pour un circuit quantique à n qubits.

La troisième ligne correspond à une implémentation d'un additionneur de Fourier quantique sur un circuit quantique à 5, 10, 15, 20 qubits. La ligne suivant correspond à cette même implémentation pour un circuit quantique à n qubits.

Il apparaît donc que les circuits quantiques compilés par la première méthode comprennent un nombre exponentiel de portes quantiques, augmentant ainsi le temps d'exécution et diminuant la précision du circuit.

D'autre part, les résultats des colonnes 2 et 3, ne sont pas vérifiables expérimentalement, étant donné que la méthode est manuelle.

Ainsi, le procédé selon l'invention permet de générer des circuits quantiques plus concis que ceux générés par l'art antérieur, tout en proposant un procédé complètement automatisé.

**Liste des documents cités**

**Littérature non-brevet**

À toute fin utile, le(s) élément(s) non-brevet(s) suivant(s) est (sont) cité(s) :

- nplcit1 : *Compiling quantum algorithms for architectures with multi-qubit gates,* Martinez et al;
- nplcit2 : *Basic circuit compilation techniques for an ion-trap quantum machine, Maslov et Use of global interactions in efficient quantum circuit constructions,* Maslov et Nam.

**Revendications**

1. Procédé de compilation d'un circuit quantique sur un processeur quantique à ions piégés, comprenant :

    - une éventuelle étape préalable de transformation du circuit quantique de manière à ce qu'il ne contienne plus que :

        \* une première catégorie prédéterminée de portes quantiques à deux qubits,
        \* et/ou des portes quantiques à un qubit,

    - une étape de compilation des portes quantiques :

        \* de manière à ce qu'elles ne contiennent que :

            ° des portes quantiques collectives ou intricatrices à N qubits d'une troisième catégorie prédéterminée,
            ° des portes quantiques à un qubit d'une quatrième catégorie prédéterminée,

        \*et de manière à ce que tout ou au moins partie de ces portes quantiques collectives ou intricatrices s'appliquent simultanément à au moins trois qubits, s'appliquent avantageusement simultanément à la majorité des qubits, s'appliquent encore plus avantageusement simultanément à tous les qubits

    - une étape de regroupement des portes quantiques compilées en un circuit quantique compilé.

2. Procédé de compilation d'un circuit quantique sur un processeur quantique à ions piégés selon la revendication 1, comprenant en outre, entre l'éventuelle étape préalable de transformation et l'étape de compilation des portes quantiques :

    - une étape de séparation dudit circuit quantique en :

        \* couches locales comprenant uniquement des portes quantiques à un qubit,
        \* couches intricatrices comprenant uniquement :

            °des portes quantiques à deux qubits de la première catégorie,
            ° et/ou des portes quantiques à un qubit d'une deuxième catégorie prédéterminée,

    - ladite étape de compilation des portes quantiques comprenant aussi :

* une étape de compilation des couches locales,
* une étape de compilation des couches intricatrices, séparée de l'étape de compilation des couches locales,
* l'étape de compilation des couches intricatrices transformant les portes quantiques de ces couches intricatrices de manière à ce qu'elles ne contiennent que :

° des portes quantiques collectives ou intricatrices à N qubits de la troisième catégorie prédéterminée,
° des portes quantiques à un qubit de la quatrième catégorie prédéterminée,

- ladite étape de regroupement des portes quantiques compilées en un circuit quantique compilé est une étape de regroupement comprenant un regroupement des couches locales compilées et des couches intricatrices compilées en un circuit quantique compilé.

3. Procédé de compilation d'un circuit quantique sur un processeur quantique à ions piégés selon la revendication 2, dans lequel l'étape de compilation des couches intricatrices comprend :

- une décomposition de chaque couche intricatrice en un polynôme de phase,
- une recomposition directe sous forme de portes quantiques de la troisième catégorie et de la quatrième catégorie de portes quantiques sans passer par une forme de portes quantiques de la première catégorie de portes quantiques.

4. Procédé de compilation d'un circuit quantique sur un processeur quantique à ions piégés selon l'une des revendications 2 ou 3, dans lequel l'étape de compilation des couches locales comprend :

- une décomposition de chaque matrice locale de couche locale en une séquence de portes quantiques d'une rotation selon l'axe Z, d'une rotation selon l'axe X, d'une rotation selon l'axe Z,
- une sous-décomposition de la rotation selon l'axe X en une séquence de portes quantiques de Hadamard, d'une rotation selon l'axe Z, de Hadamard,
- une sous-sous-décomposition, de la porte de Hadamard en une séquence de portes quantiques d'une rotation selon l'axe Z, d'une rotation selon l'axe X, d'une rotation selon l'axe Z, toutes trois rotations d'un angle de pi ou pi/2,
- une mutualisation entre qubits, des portes de rotation selon l'axe X d'un angle de pi/2.

5. Procédé de compilation d'un circuit quantique sur un processeur quantique à ions piégés selon l'une des revendications 1 à 4, **caractérisé en ce qu'**il comprend :

- une étape préalable de transformation du circuit quantique de manière à ce qu'il ne contienne plus que :

* une première catégorie prédéterminée de portes quantiques à deux qubits,
* et/ou des portes quantiques à un qubit.

6. Procédé de compilation d'un circuit quantique sur un processeur quantique à ions piégés selon l'une des revendications 1 à 5, **caractérisé en ce que**, lors de l'étape de compilation des couches intricatrices :

- le nombre de portes quantiques collectives ou intricatrices de la troisième catégorie de portes quantiques dans les couches intricatrices compilées est minimisé en priorité par rapport à la minimisation des portes quantiques de la quatrième catégorie.

7. Procédé de compilation d'un circuit quantique sur un processeur quantique à ions piégés selon l'une des revendications 1 à 6, dans lequel :

- la première catégorie prédéterminée de portes quantiques à deux qubits comprend :

* des portes quantiques diagonales à deux qubits,
* des portes quantiques CNOT,

- la troisième catégorie prédéterminée de portes quantiques à deux qubits comprend :

* des portes intricatrices Molmer-Sorensen à N qubits,
* des portes collectives à rotation suivant l'axe X,

- la quatrième catégorie prédéterminée de portes quantiques à un qubit comprend :

* des portes à déphasage local selon l'axe Z.

8. Procédé de compilation d'un circuit quantique sur un processeur quantique à ions piégés selon l'une des revendications 2 à 7, dans lequel :

- la deuxième catégorie prédéterminée de portes quantiques à un qubit comprend :

* des portes diagonales à un qubit.

9. Procédé de compilation d'un circuit quantique sur un processeur quantique à ions piégés comprenant :

- une étape de décomposition de tout ou partie du circuit quantique en un ou plusieurs polynômes de phase,
- une étape de recomposition directe dudit tout ou partie du circuit quantique sous forme de portes quantiques intricatrices de Molmer-Sorensen sans passer sous la forme de portes quantiques CNOT,
- une étape de regroupement des portes quantiques recomposées pour obtenir un circuit compilé.

Obtention d'un circuit quantique — S1

Transformation du circuit quantique en CNOT, diagonales 1 ou 2qbit, portes quantiques 1qbit — S2

Séparation en couches locales et intricatrices — S3

S6
Décomposition des matrices locales en Z X Z

S4
Décomposition des couches intricatrices en polynômes de phase

S7
Première sous-décomposition de X en P Z P

Recomposition sous forme de portes quantiques MS intricatrices et X collectives

S8
Deuxième sous-décomposition de P en Z X Z d'angle pi/2

S5

Mutualisation des portes X

S9

Regroupement des couches locales et intricatrices compilées — S10

# FIG. 1

FIG. 2a

FIG. 2b

**Data:** a set *C* of entangling gates
**Result:** a subcircuit *Layer* of local gates and a set *Ent* of entangling gates
*Layer* ← [];
*Ent* ← ∅;
**foreach** *qubit q appearing in C* **do**
  *gate* ← first gate appearing on wire *q* after *C*:
  **while** *gate is a local gate* **do**
    *Layer.append(gate)*;
    *gate* ← *get_succ(gate.q)*:
  **end**
  *Ent* ← *Ent* ∪ *{gate}*;
**end**

FIG. 3a

**Data:** an initial set $C$ of entangling gates
**Result:** a subcircuit *Layer* of entangling gates
*Layer* ← [];
$D$ ← $C$;
**while** *D is not empty* **do**
  $M$ ← *min(D)*;
  $D$ ← $D-M$;
  **foreach** *gate g in M* **do**
    *can_add* ← *True*
    **foreach** *qubit q appearing in g* **do**
      **if** *q appears in Layer* **and** *get_pred(g,q)* $\notin$ *Layer* **then**
        *can_add* ← *False*;
      **end**
    **end**
    **if** *can_add* **then**
      *Layer.append(g);*
      $D$ ← $D \cup$ *successors_ent(g)*;
    **end**
  **end**
**end**

# FIG. 3b

**Data:** the table *H* of dimensions NxN
**Result:** a sequence of operations *O* fan-out CNOTs
$O \leftarrow [\,]$;
**foreach** *i* = 0 *to N-1* **do**

    *pivot* = 0
    **foreach** *j* = *i* +1 *to N-1* **do**

        **if** $H[j][i]$ == 1 **then**
            *pivot* = *j*
            break
        **end**
    **end**
    targets = [ ]
    **foreach** *j* = 0 *to N-1* **do**
        **if** *j!* = *pivot* **then**
            **if** $H[j][i]$ == 0 *and j* == *i* **then**
                $H[j] = H[\text{pivot}] \, XOR \, H[j]$
                targets.append(j)
            **end**
            **if** $H[j][i]$ == 1 *and j!* == *i* **then**
                $H[j] = H[\text{pivot}] \, XOR \, H[j]$
                targets.append(j)
            **end**
        **end**
    **end**
    O.append([pivot, targets])
    **if** pivot! = *i* **then**
        $H[\text{pivot}] = H[\text{pivot}] \, XOR \, H[i]$
        O.append([i, [pivot]])
    **end**
**end**

# FIG. 4

**FIG. 5**

**FIG. 6**

(c)

(d)

EP 3 674 997 A1

$$U_1 \cdots U_n \equiv Z_{\delta 1 + \frac{\pi}{2}} \cdots Z_{\delta n + \frac{\pi}{2}} \quad X_{\frac{\pi}{2}} \quad Z_{\gamma 1 + \frac{\pi}{2}} \cdots Z_{\gamma n + \frac{\pi}{2}} \quad X_{\frac{\pi}{2}} \quad Z_{\beta n + \frac{\pi}{2}} \cdots Z_{\beta n + \frac{\pi}{2}}$$

**FIG. 7**

Europäisches
Patentamt

European
Patent Office

Office européen
des brevets

**RAPPORT DE RECHERCHE EUROPEENNE**

Numéro de la demande

EP 19 21 9565

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X,D | ESTEBAN A MARTINEZ ET AL: "Compiling quantum algorithms for architectures with multi-qubit gates", NEW JOURNAL OF PHYSICS, INSTITUTE OF PHYSICS PUBLISHING, BRISTOL, GB, vol. 18, no. 6, 24 juin 2016 (2016-06-24), page 63029, XP020304457, ISSN: 1367-2630, DOI: 10.1088/1367-2630/18/6/063029 [extrait le 2016-06-24] * page 1 - page 7; figures 1-6 * * page 9 - page 11 * ----- | 1-9 | INV. G06N10/00 |
| X,D | DMITRI MASLOV ET AL: "Use of global interactions in efficient quantum circuit constructions", ARXIV.ORG, CORNELL UNIVERSITY LIBRARY, 201 OLIN LIBRARY CORNELL UNIVERSITY ITHACA, NY 14853, 20 juillet 2017 (2017-07-20), XP081301865, DOI: 10.1088/1367-2630/AAA398 * page 1 - page 6 * * page 14 * ----- | 1-9 | |
| A,D | DMITRI MASLOV: "Basic circuit compilation techniques for an ion-trap quantum machine", NEW JOURNAL OF PHYSICS, vol. 19, no. 2, 22 février 2017 (2017-02-22), page 023035, XP055568611, DOI: 10.1088/1367-2630/aa5e47 * page 1 - page 8 * * page 10 - page 13 * * alinéa [0006] * ----- | 1-9 | DOMAINES TECHNIQUES RECHERCHES (IPC) G06N |

Le présent rapport a été établi pour toutes les revendications

| Lieu de la recherche | Date d'achèvement de la recherche | Examinateur |
|---|---|---|
| La Haye | 12 mai 2020 | Cilia, Elisa |

## EP 3 674 997 A1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MARTINEZ.** *Compiling quantum algorithms for architectures with multi-qubit gates*

- **MASLOV ; NAM.** *Maslov et Use of global interactions in efficient quantum circuit constructions*